Europäisches Patentamt

(19) European Patent Office

Office européen des brevets

(11) Publication number : **0 405 089 B1**

# EUROPEAN PATENT SPECIFICATION

(45) Date of publication of patent specification :
28.12.94 Bulletin 94/52

(51) Int. Cl.⁵ : **H05K 3/28,** B29C 33/68,
B29C 59/14

(21) Application number : 90107922.8

(22) Date of filing : 26.04.90

(54) **Method for the preparation of a covering film for flexible printed circuit board.**

(30) Priority : **28.04.89 JP 111588/89**

(43) Date of publication of application :
02.01.91 Bulletin 91/01

(45) Publication of the grant of the patent :
28.12.94 Bulletin 94/52

(84) Designated Contracting States :
DE GB IT

(56) References cited :
EP-A- 0 194 413
EP-A- 0 369 408
DE-A- 3 230 900

(73) Proprietor : SHIN-ETSU CHEMICAL CO., LTD.
6-1, Ohtemachi 2-chome
Chiyoda-ku Tokyo (JP)

(72) Inventor : Eguchi, Yoshitsugu
3-9809-7, Doa-honcho,
hasaki-machi
Kashima-gun, Ibaraki-ken (JP)
Inventor : Arai, Hitoshi
3-3-24, Shitte-chuo
Kamisu-machi, Kashima-gun, Ibaraki-ken (JP)

(74) Representative : Jaeger, Klaus, Dr. et al
Jaeger, Böck & Köster,
Patentanwälte,
Postfach 16 20
D-82121 Gauting (DE)

## Description

The present invention relates to a method for the preparation of a coverlay film having good dimensional stability and being suitable for use in the manufacture of flexible printed circuit boards.

Along with the more and more increasing trend in the electronic industry in recent years toward lighter and lighter or thinner and thinner design of the electronic parts as well as higher and higher performance required for electronic instruments, the demand for printed circuit boards is rapidly growing and, in particular, the application fields of flexible printed circuit boards are expanding resulting in the rapidly growing demand therefor. It is noteworthy that printed circuit boards are required to be of higher and higher performance and more and more finely patterned along with an outstanding trend toward increasingly larger sizes of the circuit pattern. In order to comply with this trend, printed circuit boards or coverlay films used in the manufacture of circuit boards are required to have higher and higher dimensional stability.

Polyimide films used as a material of the coverlay films for flexible printed circuit boards have relatively high moisture-absorptivity so that the dimension of a film highly depends on the ambient humidity expanding in a high-humidity atmosphere. Besides, coverlay films having good dimensional stability cannot be obtained when the laminating process of the film with a copper foil or a release film is performed with an excessively large tension of the film or with a hot laminating roller at an excessively high temperature.

The above described situation leads to troubles that no sufficiently high accuracy can be obtained in the patterning of the circuit on the substrate film or occurrence of warping or curling in the laminate to cause difficulties in the patterning of the circuit with high fineness or manufacture of large-sized printed circuit boards. This problem is further increased due to the variation in the shrinkage of the polyimide films from lot to lot of the industrially supplied products so that, even when the shrinkage of the circuit boards and coverlay films is taken into account in the design of the circuit pattern, displacement sometimes occurs in the processing of the coverlay films or curling of the laminated film takes place after press-bonding due to the difference in the thermal shrinkage leading to a great decrease in the yield of acceptable products of flexible printed circuit boards.

According to EP-A- 0 194 413, a polyimide film provided with a hot-sealable adhesive is used as the coverlay film of a printed circuit board.

## SUMMARY OF THE INVENTION

The present invention accordingly has an object to provide an improved method for the preparation of a polyimide-based coverlay film for flexible printed circuit boards free from the above described problems and troubles in the prior art products.

The present invention established as a result of the extensive investigations undertaken by the inventors with the above mentioned object provides a method which comprises, in the laminating of a continuously running polyimide film provided with a coating layer of a semi-cured thermosetting adhesive layer and a surface-releasing film by pressing these films together between a pair of laminating rollers to prepare a coverlay film, the steps of:

(a) subjecting the polyimide film, prior to the laminating work, to a surface treatment with low-temperature plasma in an atmosphere of an inorganic gas or to a heat treatment at a temperature in the range from 80 to 200 °C to such an extent that the thus treated film exhibits a thermal shrinkage or expansion not exceeding 0.05% by heating at 150 °C for 30 minutes in each of the longitudinal and transverse directions, said subjecting being followed by coating the polyimide film with a thermosetting adhesive which is then brought into a semi-cured state;

(b) keeping the tension of the polyimide film under lamination not to exceed 250 g/mm² in the longitudinal direction; and

(c) keeping the temperature of the laminating roller contacting the polyimide film not to exceed 100 °C.

## DETAILED DESCRIPTION OF THE PREFERRED EMBODIMENTS

As is described above, the method of the invention comprises the features (a), (b) and (c), by virtue of which the coverlay films can be imparted with greatly decreased changes in dimensions in the process for the manufacture of flexible printed circuit boards with little variation.

The polyimide film used in the preparation of the coverlay films according to the method of the invention can be a commercial product which usually has a thickness in the range from 12.5 to 125 μm and a width in the range from 500 to 1015 mm as supplied in the form of a roll. The polyimide film, which has a relatively high moisture-absorptivity, is produced by the flow-casting method involving a condensation reaction with heating so that the product film inherently suffers from a relatively large shrinkage by heating with large variations from roll to roll. This is the reason for the large shrinkage as well as large variation thereof in the conventional products of polyimide film-based laminates.

In the laminating according to the method of the invention, the base film of polyimide is, prior to coating with a thermosetting adhesive, subjected to a low-temperature plasma treatment in an atmosphere of an inorganic gas or to a heat treatment at a temperature in the range from 80 to 200 °C to a specified extent so as to reduce the subsequent thermal shrinkage or expansion of the film. Preferably, the film is subjected to both of the above mentioned plasma treatment and heat treatment, either one preceding the other. The above mentioned specified extent of the plasma treatment and/or heat treatment implies that the polyimide film after the treatment or treatments exhibits a thermal shrinkage or expansion not exceeding 0.05% in each of the longitudinal or machine direction and the transverse direction by heating at 150 °C for 30 minutes according to the procedure specified in IPC FC 241.

In the plasma treatment, the polyimide film is transferred continuously through a plasma-treatment chamber kept under a reduced pressure of 0.001 to 10 Torr or, preferably, 0.01 to 1 Torr with an inorganic gas while a direct-current or alternate-current electric power at a voltage of 0.1 to 10 kV is applied between the electrodes so as to cause glow discharge and generate low-temperature plasma in the low-pressure atmosphere of the inorganic gas by which the surface of the polyimide film is treated. The inorganic gas of the plasma atmosphere is not particularly limitative but can be selected from rare gases, e.g., helium, neon and argon, oxygen, nitrogen, carbon monoxide, air and the like. The length of time for the plasma tretment should be sufficient so as to impart the plasma-treated film with the above specified thermal shrinkage or expansion and a time of about 0.1 to 10 seconds is usually sufficient. An alternative method to the above described plasma treatment is a heat treatment of the polyimide film at a temperature in the range from 80 to 200 °C so as to remove the moisture from the film or eliminate any stress remaining in the film. The apparatus for the heat treatment is not particularly limitative including, for example, hot-air circulation ovens, infrared heaters and the like.

The base film of polyimide after the plasma treatment and/or heat treatment in the above described manner is then coated with a thermosetting adhesive which is subsequently heated to be semi-cured. The requirements for the thermosetting adhesive include high adhesive bonding strength, heat resistance to withstand molten solder alloy, adequate flowability at an elevated temperature in the press-bonding of the coverlay film to ensure full embedding of the circuit pattern and storage stability in a semi-cured state. Examples of suitable adhesives include epoxy-NBR type resins, NBR-phenolic type resins, epoxy-nylon based resins, epoxy-polyester based resins, epoxy-acrylic based resins, acrylic resins, polyamide-epoxy-phenolic based resins, polyimide resins, silicone resins and the like. The coating thickness of the adhesive is usually in the range from 10 to 50 μm as dried.

The releasing film used in the method according to the invention is a plastic film or paper imparted with releasability against the semi-cured thermosetting adhesive. Particular examples of the plastic resin of the film include polyethylenes, polypropylenes, poly(methyl pentene) resins, poly(ethylene terephthalate) resins and the like. Paper can also be used as a laminate with a film of these plastic resins or as impregnated with a suitable synthetic resin such as acrylic resins, polyvinylidene chloride and the like. It is optional according to need that the surface-releasability of these films or sheets is further enhanced by the treatment with a suitable releasing agent such as silicones. The releasing film may have a thickness, preferably, in the range from 10 to 150 μm in view of the handleableness and workability in drilling and die punching.

Following is a description of the laminating process of the pre-treated base film of a polyimide resin and the releasing film. Thus, the polyimide film is coated with a thermosetting adhesive, optionally, in the form of a solution by using a suitable coating machine such as roller coaters and the like followed by heating in an in-line heater to evaporate the solvent and to bring the adhesive into a semi-cured state. The polyimide base film thus provided with an adhesive layer on one surface is then passed through between a pair of laminating rollers together with the releasing film laid one on the other under an adequate tension in the running direction. It is usual that one of the laminating rollers in contact with the running polyimide film is at an elevated temperature to facilitate adhesive bonding between the polyimide film and releasing film.

In addition to the above described feature relative to the treatment of the base film of polyimide, the method of the invention further provides improvements relative to the laminating process of the polyimide base film coated with a semi-cured adhesive on one surface with a surface releasing film. Thus, the polyimide base film in the laminating process is kept under a tension not exceeding 250 g/mm$^2$ in the longitudinal or running direction of the film and the hot laminating roller contacting with the running polyimide base film is kept at a temperature not higher than 100 °C on the surface. In other words, the laminating process is performed under moderate conditions of the polyimide base film relative to the tension and the temperature. By this means, the polyimide base film can be laminated with little stretching and without occurrence of creases so that the coverlay films thus produced are excellent in respect of the outstandingly small subsequent shrinkage and neatly finished appearance. When the tension on the running polyimide base film under lamination is too high, a considerably large stretching of the film is caused, especially, when the film has a small thickness so that the thus laminated coverlay film may suffer a large shrinkage in the manufacturing process of flexible printed circuit boards. An excessively high temperature of the laminating roller is also an adverse condition resulting in a large shrinkage of the coverlay film sometimes with creases or an inadequately strong adhesive bonding between the releasing film and the adhesive layer with premature curing of the adhesive. The coverlay film produced in the above described manner according to the inventive method is wound up in rolls for storage or for shipping as a product.

The coverlay film is then subjected to a drilling and/or die punching work to be provided with openings according to the design of the circuit, freed from the releasing film by peeling and then press-bonded with a flexible printed circuit board, referred to as an FPC hereinafter. The coverlay film prepared according to the invention is outstandingly free from the troubles such as, for example, curling or warping of the coverlay film, shrinkage thereof after removal of the releasing film by peeling, displacement in the press-bonding with an FPC and so on.

In the following, the invention is described in more detail by way of examples although the scope of the invention is never limited thereby. Following are the procedures for the measurement of the properties of the polyimide base films and evaluation of the coverlay films as the product.

## 1. Shrinkage of polyimide base film

The polyimide base film was subjected to a heat treatment at 150 °C for 30 minutes and the shrinkage in % in the dimensions by this heat treatment, which is referred to as the shrinkage A hereinbelow, was determined according to IPC FC 241 in the longitudinal direction, referred to as MD, i.e. machine direction, and the transverse direction, referred to as TD, of the continuous-length starting film in the form of a roll. A value of shrinkage with the minus (-) sign means expansion of the film by heating.

## 2. Shrinkage of coverlay film

Measurements of the shrinkage of the coverlay film were conducted according to IPC FC 241 at two stages including the film just after removal of the releasing film by peeling and the film then subjected to a heat treatment at 150 °C for 30 minutes. The values of shrinkage thus obtained are referred to as the shrinkage B and shrinkage C, respectively, hereinbelow. Measurements were performed in the longitudinal direction, referred to MD, and the transverse direction, referred to as TD, of the continuous-length starting film in the form of a roll from which the coverlay film was prepared. A value of shrinkage with the minus (-) sign means expansion of the film by heating.

## 3. Warping of coverlay film

A square sheet of the coverlay film cut in dimensions of 300 mm by 300 mm was placed on a horizontal surface plate and the heights of the four corners raised above the plate surface were measured in mm to give an average of these four values, which is referred to as the warping A hereinbelow.

## 4. Warping of FPC

A flexible copper-foiled laminated sheet (grade GBS33S42, a product by Shin-Etsu Chemical Co.) was freed from the copper foil by etching and a coverlay film was press-bonded thereto at 160 °C for 30 minutes under a pressure of 30 kg/cm$^2$ to prepare a square test sheet having dimensions of 300 mm by 300 mm. After seasoning in an atmosphere of 60 ± 10% relative humidity at a temperature of 25 ± 5 °C, the test sheet was placed on a horizontal surface plate with the coverlay film facing upward and warping thereof was determined in the same manner as in 3. described above. The value is referred to as the warping B hereinbelow.

## 5. Appearance of coverlay film

The appearance of the coverlay film was recorded in "G" for good appearance or "P" for poor appearance when the film had no creases or had noticeable creases, respectively.

Examples 1 to 10 and Comparative Examples 1 to 8.

A polyimide film having a thickness of 12.5 μm, 25 μm, 50 μm or 75 μm purchased in the form of a roll having a width of 508 mm (Capton, a product by E.I. DuPont de Nemours Co.) was subjected to a continuous low-temperature plasma treatment by passing through a plasma treatment chamber kept under a pressure of 0.1 Torr by steadily introducing oxygen gas at a rate of 1 liter/minute. Low-temperature plasma was generated inside the chamber by applying a high-frequency electric power of 30 kilowatts at a frequency of 110 kHz and a voltage of 2 kV to the four rod-like electrodes installed in a diagonal arrangement forming an electrode column. The film was run around the electrode column keeping a 40 mm distance from the surface of each electrode at a running velocity of 50 meters/minute.

Alternatively to or succeeding the above described plasma treatment, the roll of the polyimide film having a length of 500 meters was subjected to a heat treatment for 12 hours at a temperature in the range from 80 to 150 °C in some of the Examples and 60 or 210 °C in some of the Comparative Examples.

The polyimide base films after the above described plasma treatment and/or heat treatment were each subjected to the measurement of shrinkage A in the MD and TD directions to give the results shown in Table 1 below which also gives the temperature of the heat treatment.

The thus plasma- and/or heat-treated polyimide base film was then coated with an NBR-epoxy based adhesive in a coating thickness of 35 μm as dried using a roll coater and passed through an in-line heater where the adhesive was freed from the solvent by evaporation and brought into a semi-cured state. The thus adhesive-coated polyimide film was laminated with a releasing film which was a laminate of woodfree paper having a basis weight of 80 g/m$^2$ sandwiched with two films of a poly(methyl pentene) resin (TPX, a product by Mitsui Petrochemical Co.) each having a thickness of 20 μm by using a laminating roller under a line pressure of 20 kg/cm at a line speed of 3 meters/minute to prepare a coverlay film for flexible printed circuit boards which was wound up in a roll. The tension in the polyimide film and the temperature of the laminating roller contacting the polyimide film were as shown in Table 1 which also includes the results of the evaluation tests of the thus prepared coverlay films.

In Comparative Examples 1 to 8, at least one of the essential conditions for the inventive method was not undertaken including omission of both of the plasma and heat treatments, too high tension in the polyimide film under the laminating work and too high temperature of the laminating roller in contact with the running polyimide film.

# T a b l e   1 (Part 1)

| Example No. | 1 | 2 | 3 | 4 | 5 |
|---|---|---|---|---|---|
| Film thickness, μm | 25 | 25 | 25 | 25 | 25 |
| Plasma reatment | No | Yes | Yes | Yes | Yes |
| Temperature of heat treatment, °C | 80 | 80 | 100 | 150 | – |
| Shrinkage A, %, MD | 0.04 | 0.03 | 0.01 | 0.01 | 0.03 |
| Shrinkage A, %, TD | 0.04 | 0.02 | 0.00 | 0.02 | 0.04 |
| Tension in film, $g/mm^2$ | 80 | 80 | 160 | 240 | 160 |
| Temperature of laminating roller, °C | 90 | 80 | 60 | 40 | 50 |
| Shrinkage B, %, MD | 0.03 | 0.02 | 0.02 | 0.01 | 0.03 |
| Shrinkage B, %, TD | 0.02 | 0.02 | 0.01 | 0.01 | 0.03 |
| Shrinkage C, %, MD | 0.06 | 0.04 | 0.03 | 0.03 | 0.04 |
| Shrinkage C, %, TD | 0.04 | 0.03 | 0.02 | 0.03 | 0.06 |
| Warping A, mm | 5 | 5 | 0 | 0 | 5 |
| Appearance | G | G | G | G | G |
| Warping B, mm | 5 | 0 | 0 | 0 | 0 |

# T a b l e   1 (Part  2)

| Example No. | 6 | 7 | 8 | 9 | 10 |
|---|---|---|---|---|---|
| Film thickness, μm | 25 | 12.5 | 12.5 | 50 | 75 |
| Plasma reatment | Yes | Yes | Yes | Yes | Yes |
| Temperature of heat treatment, °C | 120 | – | 120 | 120 | 120 |
| Shrinkage A, %, MD | 0.01 | 0.02 | 0.01 | 0.02 | 0.01 |
| Shrinkage A, %, TD | 0.01 | 0.01 | (–) 0.01 | (–) 0.01 | (–) 0.01 |
| Tension in film, g/mm$^2$ | 160 | 80 | 160 | 80 | 80 |
| Temperature of laminating roller, °C | 50 | 60 | 60 | 80 | 90 |
| Shrinkage B, %, MD | 0.02 | 0.02 | 0.02 | 0.02 | 0.01 |
| Shrinkage B, %, TD | 0.01 | 0.02 | 0.01 | 0.01 | 0.01 |
| Shrinkage C, %, MD | 0.04 | 0.05 | 0.06 | 0.04 | 0.03 |
| Shrinkage C, %, TD | 0.03 | 0.03 | 0.04 | 0.03 | 0.02 |
| Warping A, mm | 5 | 0 | 5 | 0 | 0 |
| Appearance | G | G | G | G | G |
| Warping B, mm | 5 | 0 | 5 | 0 | 0 |

# T a b l e  1 (Part 3)

| mp. Example No. | 1 | 2 | 3 | 4 |
|---|---|---|---|---|
| m thickness, µm | 25 | 25 | 25 | 25 |
| isma reatment | No | No | No | Yes |
| nperature of heat atment, °C | – | 60 | 210 | – |
| rinkage A, %, MD | 0.10 | 0.08 | 0.02 | 0.03 |
| rinkage A, %, TD | 0.14 | 0.12 | 0.01 | 0.04 |
| sion in film, g/mm$^2$ | 240 | 400 | 560 | 800 |
| nperature of lami- ing roller, °C | 80 | 100 | 150 | 150 |
| rinkage B, %, MD | 0.09 | 0.09 | 0.06 | 0.08 |
| rinkage B, %, TD | 0.14 | 0.10 | (–) 0.03 | 0.02 |
| rinkage C, %, MD | 0.18 | 0.16 | 0.15 | 0.18 |
| rinkage C, %, TD | 0.14 | 0.12 | 0.08 | 0.10 |
| rping A, mm | 35 | 35 | 25 | 30 |
| pearance | G | G | P | P |
| rping B, mm | 50 | 40 | 30 | 45 |

## T a b l e  1 (Part  4)

| Comp. Example No. | 5 | 6 | 7 | 8 |
|---|---|---|---|---|
| Film thickness, μm | 12.5 | 12.5 | 50 | 75 |
| Plasma reatment | No | No | No | No |
| Temperature of heat treatment, °C | - | – | - | - |
| Shrinkage A, %, MD | 0.12 | 0.12 | 0.11 | 0.10 |
| Shrinkage A, %, TD | 0.13 | 0.13 | 0.13 | 0.11 |
| Tension in film, g/mm$^2$ | 160 | 800 | 200 | 200 |
| Temperature of laminating roller, °C | 100 | 150 | 100 | 150 |
| Shrinkage B, %, MD | 0.09 | 0.13 | 0.09 | 0.08 |
| Shrinkage B, %, TD | 0.14 | 0.10 | 0.08 | 0.09 |
| Shrinkage C, %, MD | 0.16 | 0.25 | 0.18 | 0.16 |
| Shrinkage C, %, TD | 0.18 | 0.19 | 0.15 | 0.16 |
| Warping A, mm | 35 | 60 | 30 | 35 |
| Appearance | G | P | G | P |
| Warping B, mm | 40 | 70 | 30 | 30 |

## Claims

1. The method for the preparation of a coverlay film for a flexible printed circuit board, which film is a laminate of a polyimide base film and a surface-releasing film with an interposed layer of a semi-cured thermosetting adhesive, by laminating a continuously running polyimide film provided on one surface with a coating layer of a semi-cured thermosetting adhesive layer and a surface-releasing film by pressing these films together between a pair of laminating rollers, which comprises the steps of:

    (a) subjecting the polyimide film, prior to coating with the adhesive, to a surface treatment with low-temperature plasma in an atmosphere of an inorganic gas or to a heat treatment at a temperature in the range from 80 to 200 °C to such an extent that the thus treated film exhibits a thermal shrinkage or expansion not exceeding 0.05% by heating at 150 °C for 30 minutes in each of the longitudinal and transverse directions, said subjecting being followed by coating with a thermosetting adhesive which is then brought into a semi-cured state;

    (b) keeping the tension of the polyimide film under lamination not to exceed 250 g/mm$^2$ in the longitu-

dinal direction; and
(c) keeping the temperature of the laminating roller contacting the polyimide film not to exceed 100 °C.

**Patentansprüche**

1. Verfahren zur Herstellung eines Deckfilms für eine flexible gedruckte Schaltung, wobei der Film ein Laminat aus einem Polyimid-Grundfilm und einem abziehbaren Oberflächenfilm mit einer Zwischenschicht aus einem halbgehärteten wärmehärtbaren Klebstoff ist, durch Laminieren eines Polyimid-Endlosfilms, der auf einer Oberfläche mit einer Deckschicht aus einer halbgehärteten wärmehärtbaren Klebeschicht und einem abziehbaren Oberflächenfilm ausgestattet ist, indem diese Filme zwischen einem Paar von Laminierwalzen zusammengepreßt werden, welches die folgenden Stufen umfaßt:
(a) Unterziehen des Polyimidfilms vor dem Laminiervorgang einer Oberflächenbehandlung mit einem Niedertemperaturplasma in der Atmosphäre eines anorganischen Gases oder einer Wärmebehandlung bei einer Temperatur im Bereich von 80 bis 200 °C in einem solchen Ausmaß, daß der so behandelte Film eine thermische Schrumpfung oder Expansion nicht über 0,05 % aufweist, wenn er bei 150 °C 30 Minuten lang in jede der Längs- und Querrichtungen erhitzt wird, wobei auf die genannte Stufe ein Beschichten des Polyimidfilms mit einem wärmehärtbaren Klebstoff folgt, der sodann in einen halbgehärteten Zustand gebracht wird,
(b) Einhalten der Spannung des Polyimidfilms unter Laminierung, so daß 250 g/mm$^2$ in Längsrichtung nicht überschritten werden und
(c) Einhalten der Temperatur der Laminierwalze, die den Polyimidfilm berührt, so daß 100 °C nicht überschritten werden.

**Revendications**

1. Procédé de préparation d'une pellicule de couverture pour carte de circuit imprimé flexible, dans lequel la pellicule est une structure stratifiée d'un film à base de polyimide et d'un film détachable avec une couche interposée d'un adhésif thermodurcissable semi durci, par laminage d'un film polyimide avançant en continu pourvu sur une surface d'un revêtement d'une couche d'adhésif thermodurcissable semi durci et d'un film détachable en pressant ces films entre eux, au travers d'une paire de rouleaux de laminage, qui comprend les étapes suivantes :
(a) on soumet le film de polyimide, avant de l'enduire d'un adhésif, à un traitement de surface à l'aide d'un plasma basse température sous une atmosphère de gaz inorganique ou à l'aide d'un traitement thermique selon une température comprise entre 80 et 200°C, à tel point que de cette manière le film traité présente une contraction ou une dilatation thermique n'excédant pas 0,05 %, par chauffage à 150°C pendant 30 minutes dans chaque direction longitudinale et transversale, ladite étape étant suivie d'une étape d'enduction d'un adhésif thermodurcissable, qui est délivré sous un état semi durci ;
(b) on maintient la tension du film de polyimide sous laminage à une valeur n'excédant pas 250 g/mm$^2$ dans la direction longitudinale ; et
(c) on maintient la température du rouleau de laminage au contact du film de polyimide à une valeur n'excédant pas 100°C.